# EUROPEAN PATENT APPLICATION

(11) **EP 2 450 970 A1**
(43) Date of publication of application: **09.05.2012**
(21) Application number: 10401183.8
(22) Date of filing: 05.11.2010
(51) Int. Cl.: H01L 31/18, H01L 31/20

(54) **Edge isolation by lift-off**

(71) Applicant: Roth & Rau AG, 09337 Hohenstein-Ernstthal (DE)
(72) Inventor: Buechel, Arthur, 9491 Ruggell (LI); Papet, Pierre, 2068 Hauterive (CH)
(74) Representative: Steiniger, Carmen

(57) **Abstract**

The present invention includes a method for edge isolation of conductive layers deposited on front and/or back side of a solar cell, the method comprising the steps of: fabricating a solar cell device up to the step prior to the deposition of front and/or back conductive layers, depositing/applying a narrow line of coating along cell edge on one side or on both sides or on the edge of the solar cell, depositing conductive film(s) on front and/or on back side of the solar cell, and removing the narrow line of coating with wet or dry processing step.

## Description

### Background of the invention

### 1. Field of the invention:

The present invention relates to crystalline Si based photovoltaic devices, and more particularly to a method for prevention of electrical short-circuits between a front side transparent conductive film (FTCF) and a back side conductive film (BCF) of a solar cell.

### 2. State of the Art:

- Lift-off techniques are known and applied in semi-conductor industries.
- Edge isolation by laser ablation is applied on hetero junction solar cells (Sanyo patent: US005935344A).
- Prevent conductive film deposition on solar cell edge with a physical mask is known and applied to perform edge isolation.

### Summary of the invention

The present invention suggests of a novel method of electrical isolation of the front side and the back side of a hetero junction solar cell. Instead of drilling the FTCF or the BCF with a laser on the solar cell edge (Sanyo patent: US005935344A) or preventing the FTCF and/or the BCF deposition on the cell edge, a narrow line of coating is deposited on cell edge before the FTCF and/or the BCF deposition. Following the FTCF and the BCF deposition, the coating is removed (for instance by a lift-off technique) and the area where the coating was creates an electrical insulator between the front side transparent conductive film and the back side conductive film.

### Steps:

1. Coat a narrow line of coating on edge or very close to the cell edge on the top and/or the bottom side before FTCF and/or the BCF deposition. Different coatings and coating techniques can be applied to form a fine line. It is important that the coating material will have little outgasing and does not affect the subsequent deposition process negatively, moreover, the coating material has to be soluble (see step 3). For example, organic resist can be used as coating. Inkjet, screen printing, stencil printing, or spraying can be used as coating techniques.
2. Deposit the front side transparent conductive film and the back side conductive film on the hetero junction solar cell. The fine line of coating is covered at least by one of these films.
3. Remove the fine line of coating with liquid or dry etching method. The FTCF or and the BCF up to the coating is by this process removed and area where the fine line of coating was, forms an interruption between this two conductive films. This interruption avoids short circuits between the front side transparent conductive film and the back side conductive film. If the coating is an organic resist, solvent can be used to remove the resist. For soluble water resist, water can be used as removing agent.

The process presented in these three steps is often called lift-off. The use of lift-off to perform edge isolation on hetero junction is the scope of the present invention.

### Advantages

This technique doesn't create damages on the wafer (carrier recombination areas) and on amorphous or microcrystalline layer that tend to occur with laser ablation processes. Moreover, an additional advantage is that no shunts occur when the contact ribbon is attached to the cell.

As the lift-off is performed very close to the cell edge or directly on it, front and back side conductive layers present a larger surface by this technique compare to what we can obtain by physical masking. Increase the conductive area increases the cell output. This is an advantage when compared to physical masking.

### Brief description of the drawings

Fig.1a-d are side views in section illustrating steps of performing edge isolation by coating lift-off on one side for a hetero junction solar cell fabrication.
Fig.2 a-d are side views in section illustrating steps of performing edge isolation by coating lift-off on both sides for a hetero junction solar cell fabrication.
Fig.3 a-d are side views in section illustrating steps of performing edge isolation by coating lift-off on the wafer edge for a hetero junction solar cell fabrication.

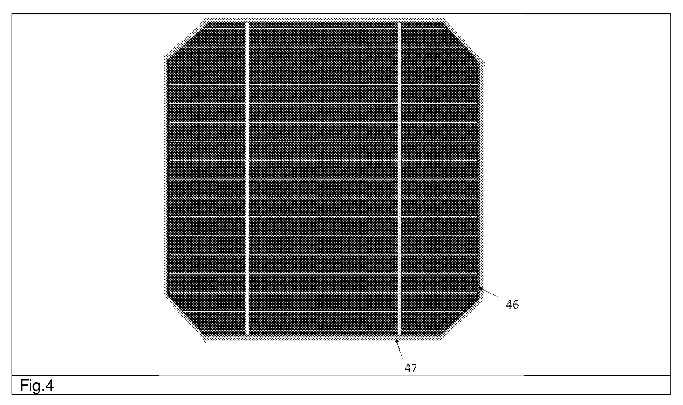

Fig.4 is an example of the top view of a final solar cell with edge isolation done by coating lift-off process. In this example coating lift-off has been performed on the front side of the hetero junction solar cell.

### Detailed description of the invention

Before the deposition of the conductive films, a narrow line of coating is deposited along cell edge. This coating pattern is close to the wafer edge or directly on it. This narrow line must be uninterrupted. The coating should be selected not to interact with conductive film deposition and should be easy to remove during the lift-off. Organic resist can be used as coating. Inkjet, screen printing, stencil printing, sprays, brush painting can be used as coating techniques.
Conductive films are deposited on one or both sides of the cell or simply on the edge of the cell.
The fine line of coating is removed of the cell by using a remover solution. This solution can be a solvent or water for water soluble coating. To perform this step, cell can be dived into a remover solution or the remover solution can be sprayed on. Remains on the cell conductive films on both side but the area where resist was is not covered by one of these films. This area electrically isolates the front side transparent conductive film (FTCF) and the back side conductive film (BCF). This interruption avoids short circuits between the front side and the back side of the hetero junction solar cell and leads to better cell performances.

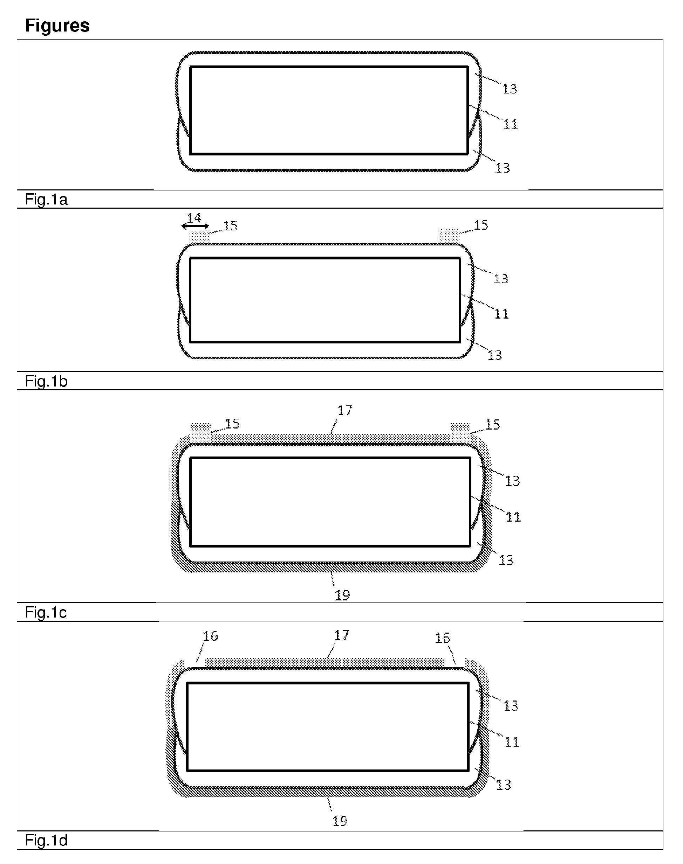

Fig.1a is a sectional view of standard hetero junction solar cell. A passivation layer and a doped amorphous or microcrystalline layer 13 are formed on one side of a silicon substrate 11 whereas an amorphous or microcrystalline layer 13 is formed on the other side.
Fig.1b a Continuous narrow line of coating 15 is deposited on one side of the solar cell along its edge. Distance 14 is as small as possible to keep conduction film 17 as large as possible.
Fig.1c Two conductive films 17 and 19 are deposited on each side of the solar cell. For the solar cell front side (illuminated solar cell side), a transparent conductive oxide is often used as material for the conductive film. About the back side, this film is not necessary transparent. The conductive film 17 and 19 can be respectively the front side transparent conductive Film (FTCF) and the back side conductive film (BCF) or the other way around.
Fig.1d By removing the coating remains an interruption 16 on the conductive film 17 where the coating was. Due to this, most of the conductive film 17 is electrically isolated of the conductive film 19.

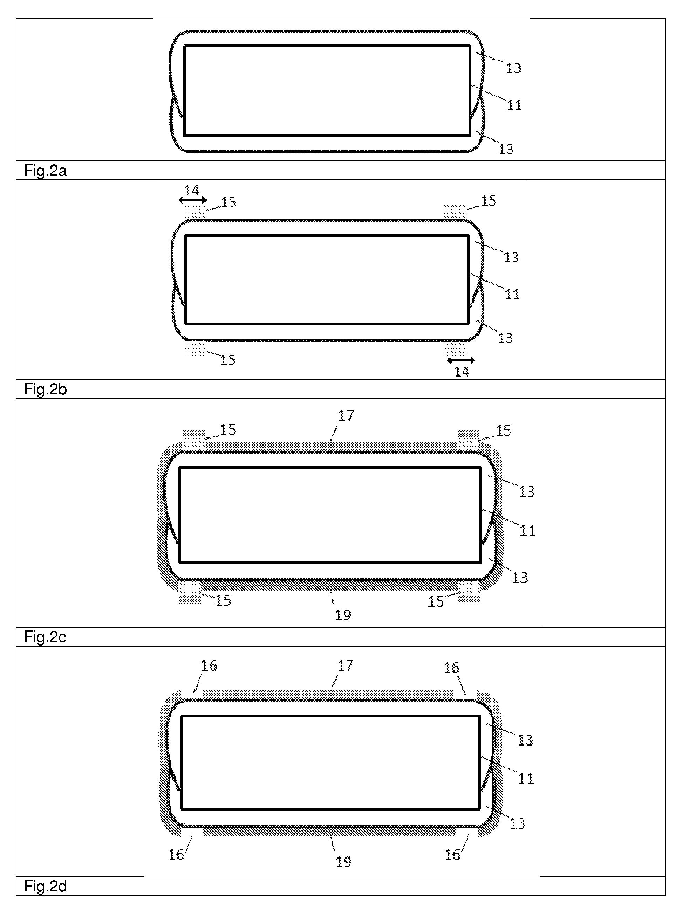

Fig.2a is a sectional view of a standard hetero junction solar cell. An amorphous or microcrystalline layer 13 is formed on one side of a silicon substrate 11 whereas an amorphous or microcrystalline layer 13 is formed on the other side.
Fig.2b a Continuous narrow line of coating 15 is deposited on both side of the solar cell along its edge. Distance 14 is as small as possible to keep conduction films 17 and 19 as large as possible.
Fig.2c Two conductive films 17 and 19 are deposited on each side of the solar cell. For the solar cell front side (illuminated solar cell side), a transparent conductive oxide is often used as material for the conductive film. About the back side, this film is not necessary transparent. The conductive film 17 and 19 can be respectively the front side transparent conductive film (FTCF) and the back side conductive film (BCF) or the other way around.
Fig.2d By removing the coating remains interruptions 16 on the conductive film 17 and 19 where the coating was. Due to this, most of the conductive film 17 is electrically isolated of the conductive film 19.

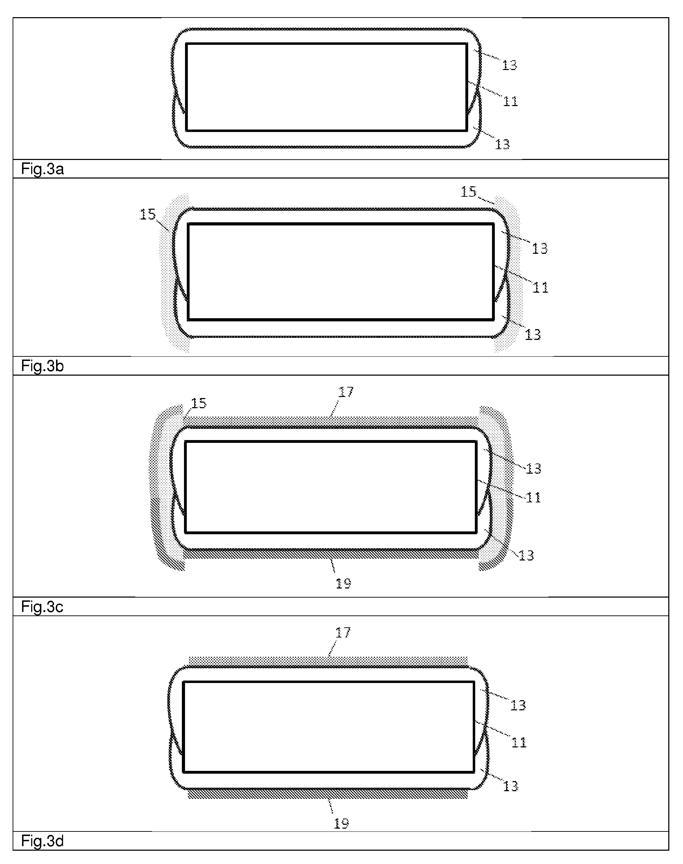

Fig.3a is a sectional view of a standard hetero junction solar cell. An amorphous or microcrystalline layer 13 is formed on one side of a silicon substrate 11 whereas an amorphous or microcrystalline layer 13 is formed on the other side.
Fig.3b A continuous narrow line of coating 15 is deposited on solar cell edge.
Fig.3c two conductive films 17 and 19 are deposited on each side of the solar cell. For the solar cell front side (illuminated solar cell side), a transparent conductive oxide is often used as material for the conductive film. About the back side, this film is not necessary transparent. The conductive film 17 and 19 can be respectively the front side transparent conductive film (FTCF) and the back side conductive film (BCF) or the other way around.
Fig.3d By removing the coating remains an interruption 16 between the conductive film 17 and 19 where the coating was. Due to this, the conductive film 17 is electrically isolated of the conductive film 19.
Fig.3 is an example of the top view of the final solar cell with edge isolation done by lift-off process. In this example lift-off has been performed on the front side of the hetero junction solar cell. The front transparent conductive film 46 is interrupted on cell edge 47.

## Claims

1. Method for edge isolation of conductive layers deposited on front and/or back side of a solar cell, the method comprising the steps of:
fabricating a solar cell device up to the step prior to the deposition of front and/or back conductive layers,
depositing/applying a narrow line of coating along cell edge on one side or on both sides or on the edge of the solar cell,
depositing conductive film(s) on front and/or on back side of the solar cell, and
removing the narrow line of coating with wet or dry processing step.

2. Method according to claim 1, wherein inkjet printing or screen printing is used to apply the coating on the cell edge.

3. Method according to claim 1 or 2 , wherein the coating (15) is applied less than 1 mm from wafer edge on one or both sides all the way to the edge.
